# EUROPEAN PATENT APPLICATION

(11) **EP 4 629 790 A1**
(43) Date of publication of application: **08.10.2025**
(21) Application number: 25168456.9
(22) Date of filing: 04.04.2025
(51) Int. Cl.: H10H 29/851, H10H 29/85

(54) **LED LAMP WITH INFRARED OUTPUT**

(30) Priority: 05.04.2024 US 202418628447
(71) Applicant: Lumileds LLC, San Jose, CA 95131 (US)
(72) Inventor: Schmidt, Peter Josef, Aachen (DE)
(74) Representative: Cohausz & Florack

(57) **Abstract**

An LED device, particularly an LED lamp, includes pump LEDs and one or more phosphors allowing the lamp to emit both visible light and SWIR (short-wave infrared) useful in, for example, aviation safety. The emission spectrum of the phosphors provides SWIR light that has high transmission in air with a high water vapor concentration, making it suitable for use with SWIR cameras employed in aircraft. The layout of the LED device also delivers the sufficient visible flux required in aviation safety.

## Description

### FIELD OF THE INVENTION

The invention relates generally to light emitting devices, particularly LEDs lamps providing infrared output for use in aviation.

### BACKGROUND

The general illumination industry has witnessed remarkable advancements in technology, with one breakthrough being the invention of Light-Emitting Diodes (LEDs). This innovation has transformed the way we perceive and experience general illumination, offering improved efficiency, durability, and versatility. Developed as a response to the limitations of traditional light source, LEDs have become a staple feature in areas like modern grounded vehicles, providing enhanced safety, aesthetics, and functionality.
In the world of aviation, improving safety during low-visibility operations is one of the most critical challenges. Toward this end, the aviation community has been working to develop flight deck display technologies that improve the pilot's ability to acquire visual information in situations where natural vision is compromised. Enhanced vision systems (EVS) for aircraft landing systems typically make use of SWIR (short-wave infrared) cameras mounted at the aircraft's nose since light in the SWIR (> 1000 nm) easily penetrates rain, fog or mist (except for the ranges 1340 - 1440 nm and 1810 - 1950 nm due to strong water vapor absorption bands). The needed SWIR emission is typically generated by medium-intensity airport approach lighting systems (ALS) equipped with halogen lamps that are driven in steady burning or flashing modes. The Energy Independence and Security Act (EISA) of 2007 requires the federal aviation administration (FAA) to transition incandescent lamps to LED technology since LEDs provide significant cost, reliability, and efficiency benefits. Current lighting systems use PAR (parabolized aluminized reflector) 38 and PAR56 lamps that will need to transition to LED lamps. To enable EVS for aircraft landing systems there is thus a need for white emitting LED lamps that provide additional SWIR emission.

Currently, prototype PAR LED lamps are being considered for use in aviation, some of which use direct emitting LEDs to produce the required output in the SWIR range. Due to the strong temperature sensitivity of direct emitting LEDs many dies may be needed to generate the required SWIR output power. Additional feedback electronics may be needed to stabilize the SWIR output under varying ambient temperatures. It would be desirable to obtain devices that work more efficiently than the current prototypes.

### SUMMARY

Embodiments of the invention include a light emitting devices with one or more LEDs as well as a number of phosphors. The phosphors may be encapsulating phosphors or remote from the LEDs. The combination of LEDs and phosphors produces both a strong output of visible light (e.g., white light) with a SWIR output that has high transmission through water saturated air. Such light emitting devices may provide the required output in aircraft systems efficiently and at relatively low operating temperatures, without requiring additional feedback electronics to stabilize the device.

These and other embodiments, features and advantages of the present invention will become more apparent to those skilled in the art when taken with reference to the following more detailed description of the invention in conjunction with the accompanying drawings that are first briefly described.

### BRIEF DESCRIPTION OF THE DRAWINGS

Figure 1 shows a schematic cross-sectional view of an example pcLED.
Figures 2A and 2B show, respectively, cross-sectional and top schematic views of an array of pcLEDs. Figure 2C shows a schematic top view of an LED wafer from which LED arrays such as those illustrated in Figures 2A and 2B may be formed.
Figure 3A shows a schematic top view of an electronics board on which an array of pcLEDs may be mounted, and Figure 3B similarly shows an array of pcLEDs mounted on the electronic board of Figure 3A.
Figure 4A shows a schematic cross-sectional view of an array of pcLEDs arranged with respect to waveguides and a projection lens. Figure 4B shows an arrangement similar to that of Figure 4A, without the waveguides.
Figure 5 schematically illustrates an example camera flash system.
Figure 6 schematically illustrates an example display (e.g., AR/VR/MR) system.
Figure 7 shows a plot of water vapor transmission and emission spectrum of phosphors suitable for use in embodiments of the present invention.
Figure 8 shows a plan view of a lamp with pump LEDs and phosphors that is capable of emitting white light and SWIR output.
Figure 9 shows a side view of a lamp with pump LEDs, a remote phosphor, and an encapsulating phosphor, that is capable of emitting white light and SWIR output.
Figure 10 shows a side view of a lamp with pump LEDs and two stacked remote phosphors that is capable of emitting white light and SWIR output.

### DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention. This description will clearly enable one skilled in the art to make and use the invention, and describes several embodiments, adaptations, variations, alternatives and uses of the invention.

As used in this specification and the appended claims, the singular forms "a," "an," and "the" include plural referents unless the context clearly indicates otherwise. Also, the term "parallel" is intended to mean "substantially parallel" and to encompass minor deviations from parallel geometries. The term "vertical" refers to a direction parallel to the force of the earth's gravity. The term "horizontal" refers to a direction perpendicular to "vertical." The term "on" means to be disposed to overlap (e.g., vertically) and/or to be directly in contact with.

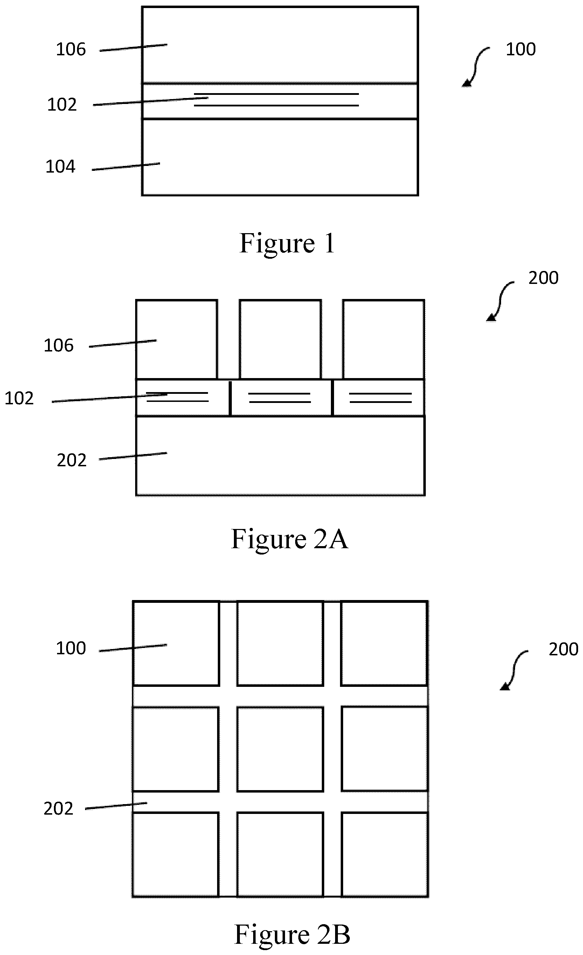

Figure 1 shows an example of an individual pcLED 100 comprising a light emitting semiconductor diode (LED) structure 102 disposed on a substrate 104, and a phosphor layer 106 (also referred to herein as a wavelength converting structure) disposed on the LED. Light emitting semiconductor diode structure 102 typically comprises an active region disposed between n-type and p-type layers. Application of a suitable forward bias across the diode structure results in emission of light from the active region. The wavelength of the emitted light is determined by the composition and structure of the active region.

The LED may be, for example, a III-Nitride LED that emits ultraviolet, blue, green, or red light. LEDs formed from any other suitable material system and that emit any other suitable wavelength of light may also be used. Other suitable material systems may include, for example, III-Phosphide materials, III-Arsenide materials, and II-VI materials.

Any suitable phosphor materials may be used, depending on the desired optical output and color specifications from the pcLED. Phosphor layers may for example comprise phosphor particles dispersed in or bound to each other with a binder material, or be or comprise a sintered ceramic phosphor plate.

Figures 2A-2B show, respectively, cross-sectional and top views of an array 200 of pcLEDs 100 including phosphor layers 106 disposed on a substrate 202. Such an array may include any suitable number of pcLEDs arranged in any suitable manner. In the illustrated example the array is depicted as formed monolithically on a shared substrate, but alternatively an array of pcLEDs may be formed from individual mechanically separate pcLEDs arranged on a substrate. Substrate 202 may optionally comprise CMOS circuitry for driving the LED and may be formed from any suitable materials.

Although Figures 2A-2B show a three-by-three array of nine pcLEDs, such arrays may include for example tens, hundreds, or thousands of LEDs. Individual LEDs may have widths (e.g., side lengths) in the plane of the array of, for example, less than or equal to 1 millimeter (mm), less than or equal to 500 microns, less than or equal to 100 microns, or less than or equal to 50 microns. LEDs in such an array may be spaced apart from each other by streets or lanes having a width in the plane of the array of, for example, hundreds of microns, less than or equal to 100 microns, less than or equal to 50 microns, less than or equal to 10 microns, or less than or equal to 5 microns.

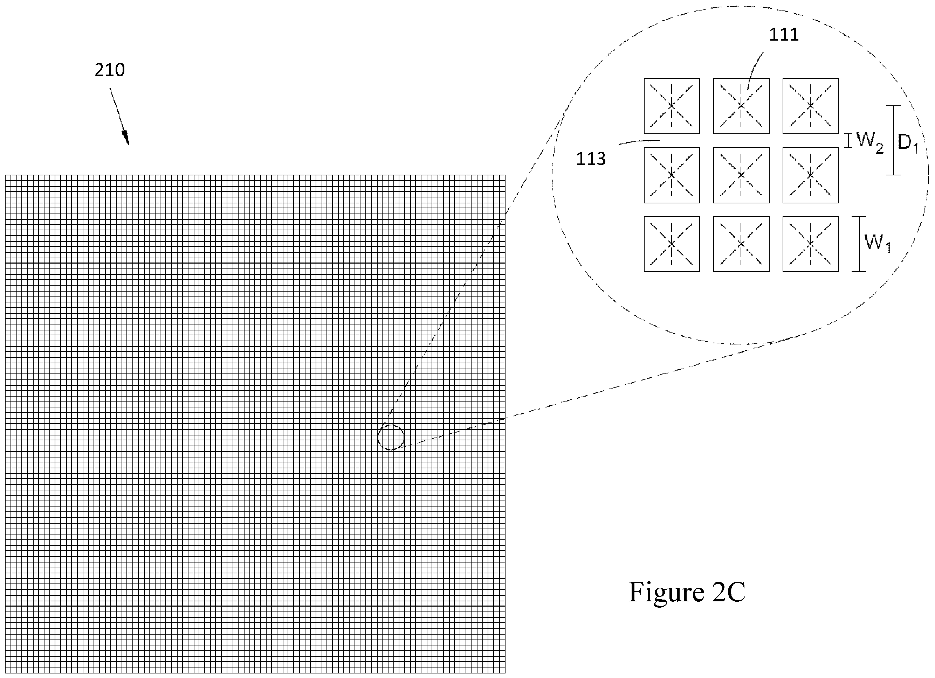

Figure 2C shows a schematic top view of a portion of an LED wafer 210 from which LED arrays such as those illustrated in Figures 2A and 2B may be formed. Figure 2C also shows an enlarged 3x3 portion of the wafer. In the example wafer individual LEDs or pcLEDs 111 having side lengths (e.g., widths) of W1 are arranged as a square matrix with neighboring LEDs or pcLEDs having a center-to-center distances D1 and separated by lanes 113 having a width W2. W1 may be, for example, less than or equal to 1 millimeter (mm), less than or equal to 500 microns, less than or equal to 100 microns, less than or equal to 50 microns, or less than or equal to 10 microns. W2 may be, for example, hundreds of microns, less than or equal to 100 microns, less than or equal to 50 microns, less than or equal to 10 microns, or less than or equal to 5 microns. D1 = W1 + W2.

An array may be formed, for example, by dicing wafer 210 into individual LEDs or pcLEDs and arranging the dice on a substrate. Alternatively, an array may be formed from the entire wafer 210, or by dividing wafer 210 into smaller arrays of LEDs or pcLEDs.

LEDs having dimensions in the plane of the array (e.g., side lengths) of less than or equal to about 50 microns are typically referred to as microLEDs, and an array of such microLEDs may be referred to as a microLED array.

Although the illustrated examples show rectangular LEDs or pcLEDs arranged in a symmetric matrix, the LEDs or pcLEDs and the array may have any suitable shape or arrangement and need not all be of the same shape or size. For example, LEDs or pcLEDs located in central portions of an array may be larger than those located in peripheral portions of the array. Alternatively, LEDs or pcLEDs located in central portions of an array may be smaller than those located in peripheral portions of the array.

In an array of pcLEDs, all pcLEDs may be configured to emit essentially the same spectrum of light. Alternatively, a pcLED array may be a multicolor array in which different pcLEDs in the array may be configured to emit different spectrums (colors) of light by employing different phosphor compositions. Similarly, in an array of direct emitting LEDs (i.e., not wavelength converted by phosphors) all LEDs in the array may be configured to emit essentially the same spectrum of light, or the array may be a multicolor array comprising LEDs configured to emit different colors of light.

The individual LEDs or pcLEDs in an array may be individually operable (addressable) and/or may be operable as part of a group or subset of (e.g., adjacent) LEDs or pcLEDs in the array.

An array of LEDs or pcLEDs, or portions of such an array, may be formed as a segmented monolithic structure in which individual LEDs or pcLEDs are electrically isolated from each other by trenches and/or insulating material, but the electrically isolated segments remain physically connected to each other by portions of the semiconductor structure.

An LED or pcLED array may therefore be or comprise a monolithic multicolor matrix of individually operable LED or pcLED light emitters. The LEDs or pcLEDs in the monolithic array may for example be microLEDs as described above.

A single individually operable LED or pcLED or a group of adjacent such LEDs or pcLEDs may correspond to a single pixel (picture element) in a display. For example, a group of three individually operable adjacent LEDs or pcLEDs comprising a red emitter, a blue emitter, and a green emitter may correspond to a single color-tunable pixel in a display.

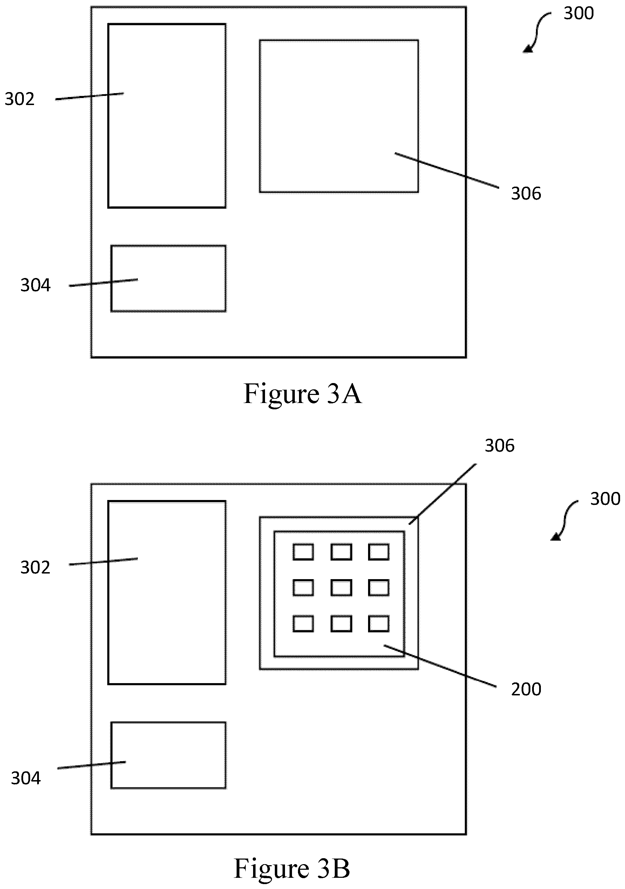

As shown in Figures 3A-3B, an LED or pcLED array 200 may be mounted on an electronics board 300 comprising a power and control module 302, a sensor module 304, and an attach region 306. Power and control module 302 may receive power and control signals from external sources and signals from sensor module 304, based on which power and control module 302 controls operation of the LEDs/pcLEDs. Sensor module 304 may receive signals from any suitable sensors, for example from temperature or light sensors. Alternatively, array 200 may be mounted on a separate board (not shown) from the power and control module and the sensor module.

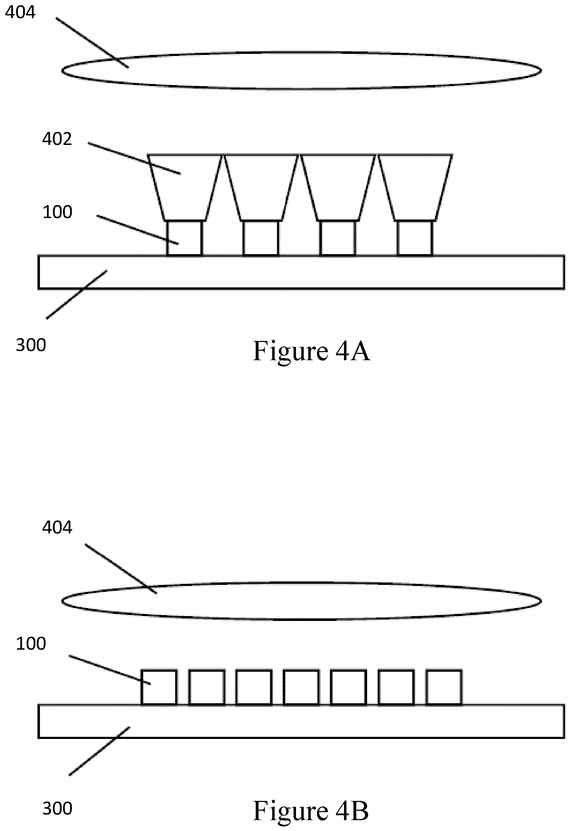

Individual LEDs or pcLEDs may optionally incorporate or be arranged in combination with a lens or other optical element located adjacent to or disposed on the phosphor layer. Such an optical element, not shown in the figures, may be referred to as a "primary optical element". In addition, as shown in Figures 4A-4B an array 200 (for example, mounted on an electronics board 300) may be arranged in combination with secondary optical elements such as waveguides, lenses, or both for use in an intended application. In Figure 4A, light emitted by pcLEDs 100 is collected by waveguides 402 and directed to projection lens 404. Projection lens 404 may be a Fresnel lens, for example. This arrangement may be suitable for use, for example, in automobile headlights. In Figure 4B, light emitted by pcLEDs 100 is collected directly by projection lens 404 without use of intervening waveguides. This arrangement may be particularly suitable when LEDs or pcLEDs can be spaced sufficiently close to each other and may also be used in automobile headlights as well as in camera flash applications. A microLED display application may use similar optical arrangements to those depicted in Figures 4A-4B, for example.

In another example arrangement, a central block of LEDs or pcLEDs in an array may be associated with a single common (shared) optic, and edge LEDs or pcLEDs located in the array at the periphery of the central bloc are each associated with a corresponding individual optic.

Generally, any suitable arrangement of optical elements may be used in combination with the LED and pcLED arrays described herein, depending on the desired application.

LED and pcLED arrays as described herein may be useful for applications requiring or benefiting from fine-grained intensity, spatial, and temporal control of light distribution. These applications may include, but are not limited to, precise special patterning of emitted light from individual LEDs or pcLEDs or from groups (e.g., blocks) of LEDs or pcLEDs. Depending on the application, emitted light may be spectrally distinct, adaptive over time, and/or environmentally responsive. Such arrays may provide pre-programmed light distribution in various intensity, spatial, or temporal patterns. The emitted light may be based at least in part on received sensor data and may be used for optical wireless communications. Associated electronics and optics may be distinct at an individual LED / pcLED, group, or device level.

An array of independently operable LEDs or pcLEDs may be used in combination with a lens, lens system, or other optic or optical system (e.g., as described above) to provide illumination that is adaptable for a particular purpose. For example, in operation such an adaptive lighting system may provide illumination that varies by color and/or intensity across an illuminated scene or object and/or is aimed in a desired direction. Beam focus or steering of light emitted by the LED or pcLED array can be performed electronically by activating LEDs or pcLEDs in groups of varying size or in sequence, to permit dynamic adjustment of the beam shape and/or direction without moving optics or changing the focus of the lens in the lighting apparatus. A controller can be configured to receive data indicating locations and color characteristics of objects or persons in a scene and based on that information control LEDs or pcLEDs in an array to provide illumination adapted to the scene. Such data can be provided for example by an image sensor, or optical (e.g., laser scanning) or non-optical (e.g., millimeter radar) sensors. Such adaptive illumination is increasingly important for automotive (e.g, adaptive headlights), mobile device camera (e.g., adaptive flash), VR, and AR applications such as those described below.

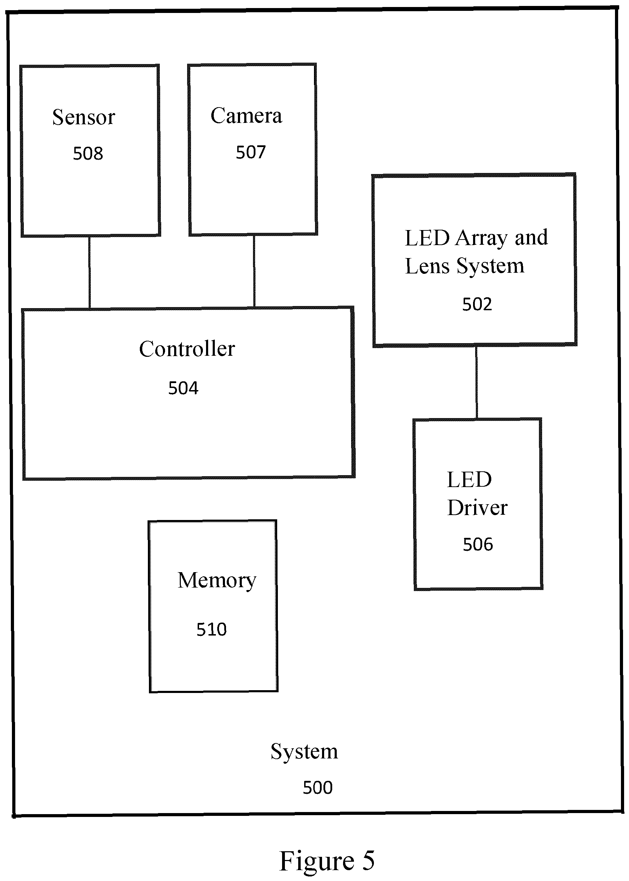

Figure 5 schematically illustrates an example camera flash system 500 comprising an LED or pcLED array and lens system 502, which may be or comprise an adaptive lighting system as described above in which LEDs or pcLEDs in the array may be individually operable. In operation of the camera flash system, illumination from some or all of the LEDs or pcLEDs in array and lens system 502 may be adjusted - deactivated, operated at full intensity, or operated at an intermediate intensity. The array may be a monolithic array, or comprise one or more monolithic arrays, as described above. The array may be a microLED array, as described above.

Flash system 500 also comprises an LED driver 506 that is controlled by a controller 504, such as a microprocessor. Controller 504 may also be coupled to a camera 507 and to sensors 508 and operate in accordance with instructions and profiles stored in memory 510. Camera 507 and LED or pcLED array and lens system 502 may be controlled by controller 504 to, for example, match the illumination provided by system 502 (i.e., the field of view of the illumination system) to the field of view of camera 507, or to otherwise adapt the illumination provided by system 502 to the scene viewed by the camera as described above. Sensors 508 may include, for example, positional sensors (e.g., a gyroscope and/or accelerometer) and/or other sensors that may be used to determine the position and orientation of system 500.

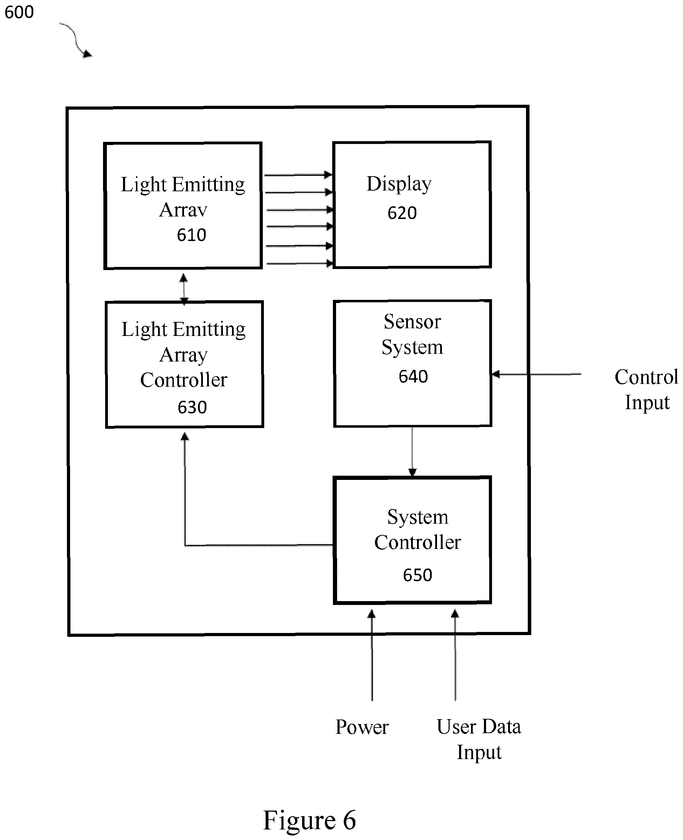

Figure 6 schematically illustrates an example display (e.g., AR/VR/MR) system 600 that includes an array 610 of individually operable LEDs or pcLEDs, a display 620, a light emitting array controller 630, a sensor system 640, and a system controller 650. Array 610 may be a monolithic array, or comprise one or more monolithic arrays, as described above. The array may be monochromatic. Alternatively, the array may be a multicolor array in which different LEDs or pcLEDs in the array are configured to emit different colors of light, as described above. The array may therefore be or comprise a monolithic multicolor matrix of individually operable LED or pcLED light emitters, which may for example be microLEDs as described above. A single individually operable LED or pcLED or a group of adjacent such LEDs or pcLEDs in the array may correspond to a single pixel (picture element) in the display. For example, a group of three individually operable adjacent LEDs or pcLEDs comprising a red emitter, a blue emitter, and a green emitter may correspond to a single color-tunable pixel in the display. Array 610 can be used to project light in graphical or object patterns that can support AR/VR/MR systems

Control input is provided to the sensor system 640, while power and user data input is provided to the system controller 650. In some embodiments modules included in system 600 can be compactly arranged in a single structure, or one or more elements can be separately mounted and connected via wireless or wired communication. For example, array 610, display 620, and sensor system 640 can be mounted on a headset or glasses, with the light emitting array controller and/or system controller 650 separately mounted.

System 600 can incorporate a wide range of optics (not shown) to couple light emitted by array 610 into display 620. Any suitable optics may be used for this purpose.

Sensor system 640 can include, for example, external sensors such as cameras, depth sensors, or audio sensors that monitor the environment, and internal sensors such as accelerometers or two or three axis gyroscopes that monitor an AR/VR/MR headset position. Other sensors can include but are not limited to air pressure, stress sensors, temperature sensors, or any other suitable sensors needed for local or remote environmental monitoring. In some embodiments, control input can include detected touch or taps, gestural input, or control based on headset or display position.

In response to data from sensor system 640, system controller 650 can send images or instructions to the light emitting array controller 630. Changes or modification to the images or instructions can also be made by user data input, or automated data input as needed. User data input can include but is not limited to that provided by audio instructions, haptic feedback, eye or pupil positioning, or connected keyboard, mouse, or game controller.

As noted above, LEDs may be combined with one or more phosphors in order to provide the necessary visible and SWIR outputs required for aviation purposes. Embodiments of this invention include an LED lamp including one or more white pcLEDs (phosphor-converted LED) with one or more SWIR pcLEDs to reduce the complexity of the lamp configuration and the number of needed SWIR emitters to generate the required output characteristics.

The SWIR emission spectrum of the SWIR pcLEDs uses a spectral power distribution (SPD) that matches well with the water vapor absorption characteristics in the SWIR wavelength range, since water vapor shows very strong absorption bands in the ~1120 nm and ~1380 nm spectral ranges.

The LED lamp includes one or more white pcLEDs that emits light of visible white (e.g., light within and/or encompassing the whole wavelength range of 380-700 nm, e.g., a range of 400-700 nm). Examples of suitable white emitting pcLEDs include LUXEON 5050 LEDs. The one or more white pcLEDs deliver the required amount of white light flux (e.g. from 500-800 lumens) and correlated color temperature (CCT) in the 2700 - 6500 Kelvin range, such as from 2700 - 5000 K, such as from 2700-4000 K, such as from 2700-3000 K. A higher CCT compared to halogen lamps may be desirable to enhance the vision contrast to amber of yellow airport signal lights. For example, the CCT may be from 3000 - 6500 K, such as from 3000 - 5000 K, such as from 3000 - 4000 K.

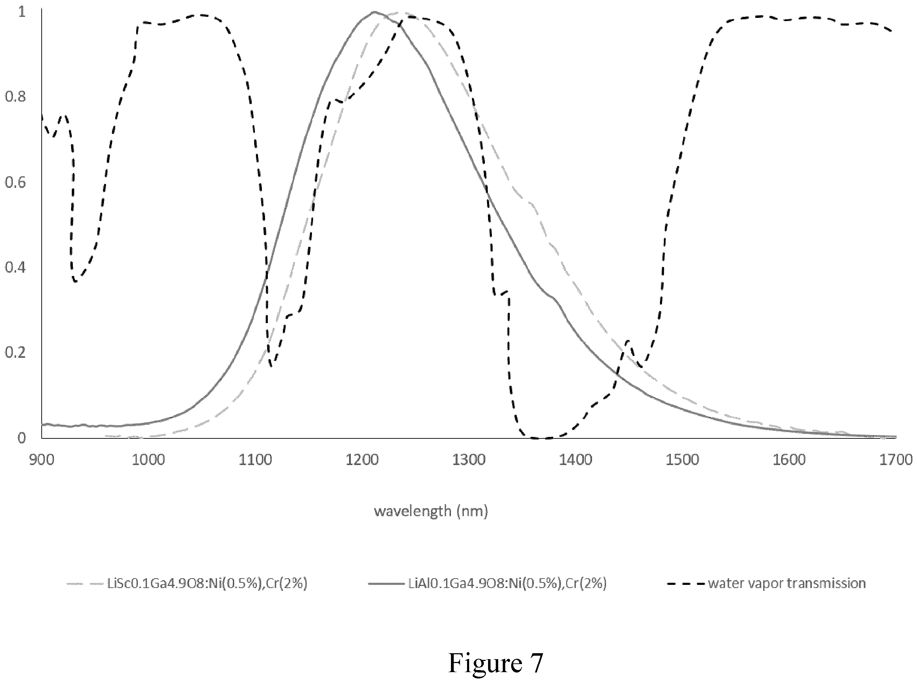

The LED lamp includes one or more SWIR pcLEDs (which may include the pump LEDs with the phosphor converter disposed in their light path). The SWIR pcLEDs may emit light from a range of 900 - 1700 nm, such as from 1000 - 1600 nm, such as from 1100-1600 nm. with an SPD having an emission maximum in the 1120 -1380 nm wavelength range (such as from 1200 - 1300 nm, such as from 1200-1250 nm) to enable a high transmission through water vapor saturated air. This is important to see through fog, as otherwise the emitted IR will become absorbed. Phosphor having these useful SPDs are shown in Fig. 7, where the x-axis represents the wavelength and the y-axis represents water vapor transmission (where transmission is 0.0 absorption is 100%) or scaled emission power for the phosphors (at 1.0 the SWIR has the highest emitted power). Suitable phosphors may include or consist of, for example, phosphor materials crystallized into the spinel, perovskite, and/or garnet structure types, and which are doped with Ni²⁺, or Ni²⁺ and Cr³⁺. Such SWIR phosphors include Ni²⁺, or Ni²⁺ and Cr³⁺, doped XY₂O₄ spinels, ABO₃ perovskites and M₃B₂T₃O₁₂ garnets.

Spinel type SWIR phosphors that emit light in the 1000 - 1700 nm range may be AE_{1-x-z}A_{z+0.5(x-y)}D_{2+0.5(x-y)-z-u}E_{z}O₄:Ni_{y},Cr_{u_}with AE = Mg, Zn, Co, Be or mixtures from this group of divalent atoms, A = Li, Na, Cu, Ag or mixtures from this group of monovalent atoms, D = Ga, Al, B, In, Sc or mixtures from this group of trivalent atoms and E = Si, Ge, Sn, Ti, Zr, Hf or mixtures from this group of tetravalent atoms; where 0 ≤ x ≤ 1, 0 < y ≤ 0.1, 0 ≤ z ≤ 1, 0 ≤ u ≤ 0.2. Examples of spinel type SWIR phosphors are the inverse spinel phosphors codoped with Cr(III) and Ni(II) of composition LiGa₅₋ₓMₓO₈:Cr,Ni (M = Al, Sc; 0 ≤ x ≤ 0.6). For example, Fig. 7 shows two suitable SWIR phosphors either or both of which may be used as the phosphor converters 830 in embodiments of the invention, LiSc_{0.1}Ga_{4.0}O₈:Ni(0.5%), Cr(2%) and LiAl_{0.1}Ga_{4.9}O₈:Ni(0.5%),Cr(2%).

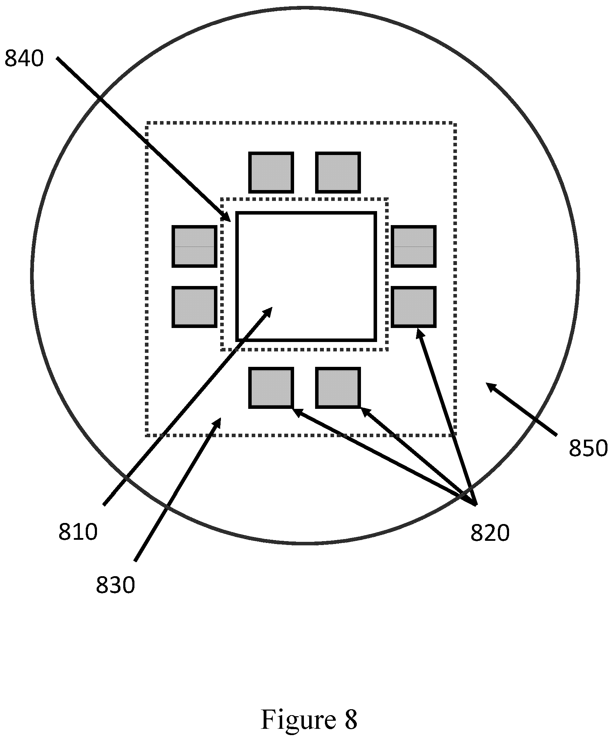

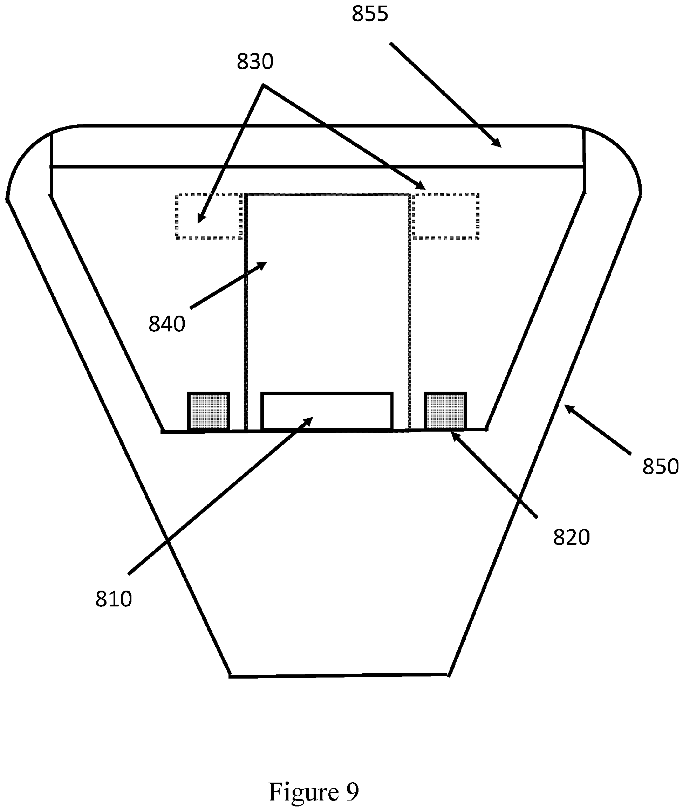

To enable the required output power in the visible and SWIR spectral range a number of discrete pcLEDs may be combined in a lamp system. A practical example may comprise one or more pc white LEDs (e.g., LUXEON 5050 LEDs) for the visible spectral range and one or more pc SWIR LEDs (e.g., LUXEON Rubix-type LEDs). In the example shown in Fig. 8 and 9, this may be a PAR 38 lamp including a single white emitting LUXEON 5050 LED surrounded by eight LUXEON Rubix pcIR LEDs with a phosphor converter emitting around the 1200 nm spectral range to provide white light and IR power in the 600 lm and 500 mW range, respectively. the lamp may comprise a housing 850 that bounds/surrounds all of the LEDs and has a socket or screw base that provides for an electrical connection powering all of the LEDs in the lamp. The housing 850 may be or include plastic or metal and may enclose the LEDs and may be IP65 water resistant or better. The housing 850 may include a transparent light emitting side 855 that may be plastic or glass. The phosphor converter 830 (shown with dashed lines in Fig. 8) shared by the SWIR pump LEDs 820 may be a ceramic LGSNC converter. When the phosphor converter 830 is a ceramic converter it may be spaced apart from the SWIR pump LEDs 820. The phosphor converter 830 may be a continuous shape, such as a ring or rectilinear band with a hole so that it does not overlap the white pump LEDs 810. That is, the phosphor converter 830 shared by multiple or all of the SWIR pump LEDs 820 may be monolithic. The phosphor converter 830 may also be a powder phosphor dispersed in a binder, such as a silicone matrix; in this case it may be in direct contact with the of the SWIR pump LEDs 820. Each of the white pump LEDs 810 and each of the SWIR pump LEDs 820 shown in Fig. 8 may themselves be packages comprising multiple white pump LEDs or multiple IR pump LEDs, respectively. Each of the white pump LEDs 810 (and/or IR pump LEDs 820) may be a lead-frame package shared by and overlapping all of their individual LEDs, where the lead-frame package each has an anode pad and a cathode pad, which may be in direct contact with the housing 850, and may have other shared elements within the lead-frame package such as a heat sink, a PCB board, and/or LED driver. If the white pump LEDs 810 form a package comprising multiple white pump LEDs, then those white pump LEDs are a closer distance to adjacent white pump LEDs than they are to adjacent SWIR pump LEDs 820. The white pump LEDs 810 may all be encapsulated by phosphor converter 840 spaced apart from the SWIR pump LEDs 820 and/or the phosphor converter 830. The IR pump LEDs 820 may each be high power chip scale package (CSP) like Luxeon Rubix, which allows a cermic converter to be directly attached to the primary light emitting surface. The aggregate area of the SWIR pump LEDs 820 may be smaller than the aggregate area of the white pump LEDs 810, and the white pump LED 810 may have an area greater than each of the SWIR pump LEDs 820, when viewed in the plan view shown in Fig. 8; however, this is not required. The arrangement of the LEDs in the lamp may be symmetric, and the SWIR pump LEDs 820 may be disposed on a same planar surface of the housing 850 as the white pump LEDs 820. The planar surface may be reflective.

The white pump LEDs 810 may emit visible light, e.g. visible blue light (such as from 450-495 nm). A phosphor converter 840 may be disposed in the path of the white pump LEDs 810 which absorb light from the pump LEDs to emit light of a different wavelength that, when combined with the light of the pump LEDs, is a white emission in the visible spectral range and appears white to a human observer. For example, a phosphor converter 840 emitting yellow may be disposed in the path of the white pump LEDs 810. The CRI range of the lamp may be from 70-95, such as from 80-85 if the CIE color point of the emitted visible light is close to that of a Planckian emitter, for example within an ANSI/NEMA C78 377A color bin. The phosphor converter 840 may not be disposed in the path of the SWIR pump LEDs 820, and may not overlap the phosphor converter 830. The phosphor converter 840 may also lead to emission of light with an "off-Planckian" color point (to compensate for blue leakage light of the SWIR LEDs), like a color point with a yellow tint (above Planckian). As shown in Fig. 9, the phosphor converters 830 overlap the SWIR pump LEDs 820 in the vertical direction and/or are disposed in the light path of light emitted by the SWIR pump LEDs 820. The phosphor converter 840 may overlap the white pump LEDs 810 in the vertical and/or horizontal direction and/or are disposed in the light path of light emitted by the white pump LEDs 810. The phosphor converter 840 may be a powder phosphor in a binder such as silicone, or a ceramic phosphor. In the former case, the phosphor converter 840 may be in direct contact with white pump LEDs 810. A ceramic phosphor may be preferable for the SWIR pump LEDs 820 as it may not have organic material in the binder which absorbs in the IR, and may have better heat dissipation than a powder phosphor which may be useful since the phosphor conversion to IR is often hotter than phosphor conversion to another visible light wavelength.

The SWIR pump LEDs 820 may be similar or identical with the white pump LEDs 810, e.g., they may emit visible blue light. However, this is not a requirement and the SWIR pump LEDs 820 may emit a different wavelength of light from the white pump LEDs 810, e.g., visible red or green light.

When the SWIR pump LEDs 820 emit visible light into the phosphor converter 830, some of the pump light may not be converted by the phosphor converter 830. This unconverted light may or may not be desired in the final emission. A number of solutions may be implemented if this unconverted light is not desired. For example, a dichroic filter may be placed above and/or on top of the phosphor converter 830. The dichroic filter may filter out most or all (e.g., 90-100%) of the light directly emitted form the SWIR pump LEDs 820 while allowing most or all (e.g., 90-100%) of the converted light emitted by the phosphor converter 830 (which may be IR light) through. The light which is not transmitted may be back-reflected. Alternatively or additionally, an absorbing layer may be placed above and/or on top of the phosphor converter 830, which absorbs visible light (e.g., with 90-100% absorption) but transmits SWIR light (e.g., with 90-100% transmission. The dichroic filter and/or the absorbing layer may overlap with the SWIR pump LEDs 820 and may not overlap with the white pump LEDs 810 in a plan view, although this is not a requirement and they may overlap with both pump LEDs in the lamp.

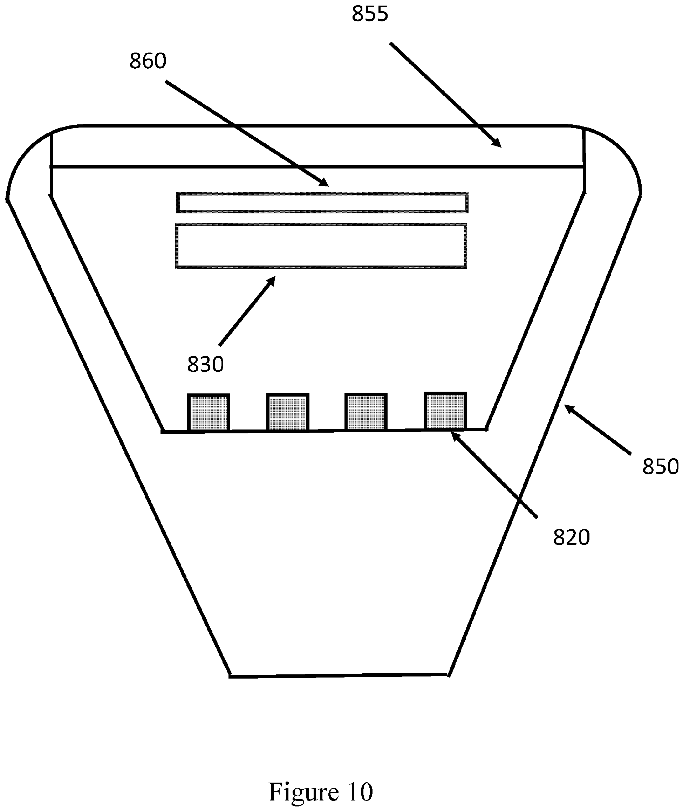

Alternatively or additionally, a second phosphor converter 860 may be placed above and/or on top of the phosphor converter 830 to convert part of the light from the SWIR pump LEDs 820 into visible light of a different color to create white visible light. The emitted light from the second phosphor converter 860 is a different color both from light emitted by both the SWIR pump LEDs 820 and the phosphor converter 830. For example, the second phosphor converter 860 may be a yellow phosphor converting blue light from the SWIR pump LEDs 820 into yellow light to create visible white light. The second phosphor converter may be spaced apart to not be in direct contact with the SWIR pump LEDs 820. In embodiments of the invention, the second phosphor converter may allow omission of the white pump LEDs 810, as shown in Fig. 10. In this case, the phosphor converter 830 may have a solid shape without a hole in the center, since the white pump LEDs 810 are not present. The second phosphor converter 860 may have a thinner thickness than the phosphor converter 830, although this is not a requirement. The second phosphor converter 860 may have a length and/or width in the horizontal direction that is/are a same as that of the phosphor converter 830. The second phosphor converter 860 may be arranged as part of transparent light emitting side 855; in this case it may be an extruded plastic component with (yellow-emitting) phosphor powder mixed in.

The disclosures provided in this specification are intended to illustrate but not necessarily to limit the described implementation. As used herein, the term "implementation" means an implementation that serves to illustrate by way of embodiments but not limitation. The techniques described in the preceding text and figures can be mixed and matched as circumstances demand to produce alternative implementations. It will be apparent to those of ordinary skill in the art that numerous variations, changes, and substitutions of the embodiments described above can be made without departing from the invention. Furthermore, it shall be understood that all aspects of the invention are not limited to the specific depictions, configurations or relative proportions set forth herein which depend upon a variety of conditions and variables. It should be understood that various alternatives to the embodiments of the invention described herein may be employed in practicing the invention. It is therefore contemplated that the invention shall also cover any such alternatives, modifications, variations or equivalents. All such alternatives will be apparent to one skilled in the art in light of this disclosure and are intended to fall within the scope of the appended claims.

## Claims

1. A light emitting device comprising:
a housing having a first surface;
first LEDs disposed on the first surface and configured to emit first light of a first wavelength, the first light being visible light;
second LEDs disposed adjacent to the first LEDs and configured to emit second light of a second wavelength;
a first phosphor structure disposed in a light path of the first LEDs, the first phosphor structure configured to absorb the first light and emit third light of a third wavelength, the third light being visible light;
a second phosphor structure disposed in a light path of the second LEDs, the second phosphor structure configured to absorb light of the second wavelength and emit fourth light of the fourth wavelength, the fourth wavelength having a wavelength from 900-1700 nm.

2. The light emitting device of claim 1, wherein the second phosphor structure comprises ceramic phosphor.

3. The light emitting device of claim 2, wherein the second phosphor structure is spaced apart from the second LEDs.

4. The light emitting device of claim 2, wherein the second phosphor structure comprises a inverse spinel phosphor codoped with Cr(III) and Ni(II) of composition LiGa₅₋ₓMₓO₈:Cr,Ni (M = Al, Sc; 0 ≤ x ≤ 0.6).

5. The light emitting device of claim 1, wherein the second phosphor structure overlaps all the second LEDs in a vertical direction and does not overlap any of the first LEDs in the vertical direction.

6. The light emitting device of claim 1, wherein the second phosphor structure is a monolithic structure comprising a shape with a hole.

7. The light emitting device of claim 1, wherein the second phosphor structure is spaced apart from the first phosphor structure.

8. The light emitting device of claim 1, wherein the second phosphor structure has a spectral power distribution with a wavelength emission maximum of from 1120-1380 nm.

9. The light emitting device of claim 1, wherein the first phosphor structure comprises powder phosphor dispersed in a binder.

10. The light emitting device of claim 1, wherein the first phosphor structure is in direct contact with the first LEDs.

11. The light emitting device of claim 1, wherein the first LEDs and second LEDs are enclosed within the housing.

12. The light emitting device of claim 1, wherein the first LEDs are comprised in a first package.

13. The light emitting device of claim 12, wherein the first package is a lead frame package comprising an anode pad and a cathode pad.

14. The light emitting device of claim 1, wherein the second LEDs are comprised in a plurality of second packages.

15. The light emitting device of claim 1, wherein the second packages are each a lead frame package comprising an anode pad and a cathode pad.
